# EUROPEAN PATENT APPLICATION

(11) **EP 4 123 347 A1**
(43) Date of publication of application: **25.01.2023**
(21) Application number: 21862055.7
(22) Date of filing: 25.08.2021
(51) Int. Cl.: G02B 5/32, G03H 1/02

(54) **METHOD FOR REPLICATING LARGE-AREA HOLOGRAPHIC OPTICAL ELEMENT, AND LARGE-AREA HOLOGRAPHIC OPTICAL ELEMENT REPLICATED THEREBY**

(30) Priority: 25.08.2020 KR 20200107292
(71) Applicant: Lg Chem, Ltd., Seoul 07336 (KR)
(72) Inventor: JUNG, Bo Ra, Daejeon 34122 (KR); LEE, Joon Young, Daejeon 34122 (KR); SONG, Min Soo, Daejeon 34122 (KR); KWON, Do Kyeong, Daejeon 34122 (KR); YOO, Yeon Jae, Daejeon 34122 (KR)
(74) Representative: Hoffmann Eitle
(86) International application number: PCT/KR2021/011346
(87) International publication number: WO 2022/045758

(57) **Abstract**

A method for replicating a holographic optical element and a holographic optical element replicated thereby are provided. The holographic optical element is larger than a master. The master has a holographic grating pattern generated on the master by interference of the reflected, diffracted or transmitted beam generated by irradiating the master having a specific diffraction grating pattern formed thereon with a laser beam.

## Description

### BACKGROUND

### 1. Technical Field

This application claims the benefit of the filing date of Korean Patent Application No. 10-2020-0107292 filed with the Korean Intellectual Property Office on August 25, 2020, the entire content of which is incorporated herein by reference.

The present disclosure relates to a method for replicating a holographic optical element and a holographic optical element replicated thereby, and more particularly, to a method for replicating a holographic optical element which is larger than a master while having a holographic grating pattern generated on the master by interference of the reflected, diffracted or transmitted beam generated by irradiating the master having a specific diffraction grating pattern formed thereon with a laser beam.

### 2. Related Art

A holographic optical element is an element having a specific grating pattern formed by a reference beam and an object beam, and is an element necessary for recording and reproducing a hologram.

When this holographic optical element is irradiated with a reference beam, a hologram may be reproduced. In a conventional art, as a method that uses the characteristics of this holographic optical element, there is a replication technique for fabricating another holographic optical element having the same holographic grating pattern by using the holographic optical element as a master.

This process of replicating a holographic optical element is characterized in that the process method itself is relatively simple, and thus it is possible to mass-produce a holographic optical element even at low costs. Only when the quality of the master to be replicated is uniform and maintained over a long time, holographic optical elements having constant quality may be produced despite repeated replication.

With the development of augmented reality (AR) display devices, diffractive light guide plates having nanopatterned gratings formed thereon may be used to fabricate such devices. The diffractive light guide plates include a diffractive optical element and a holographic optical element. As augmented reality devices such as a vehicle head-up display (HUD) have developed and their uses have diversified, large-sized diffractive light guide plates have been required. However, when a master fabricated by a nanoimprint lithography method is used, a problem arises in that the large-sized diffractive light guide plate is not applicable because it is difficult to fabricate the master to have a large size. When an AR display device is embodied using a surface-relief grating (SRG) type diffractive optical element (DOE) fabricated by a nanoimprint lithography method, the user's view may be obstructed due to external light diffraction because the difference in the refractive index of the grating is as great as 0.5.

Accordingly, there is a need for a technology capable of replicating a large holographic optical element, which causes less visual obstruction by external light diffraction even while using a master fabricated by a nanoimprint lithography method.

The above-described background art is technical information that the present inventors have retained to derive embodiments of the present disclosure or have obtained in the course of deriving the embodiments of the present disclosure, and may not be regarded as publicly known technology known to the general public before the filing of the embodiments of the present disclosure.

### SUMMARY

The present disclosure has been made in order to solve the above-described problems, and an object of the present disclosure is to provide a method for replicating a holographic optical element, which is capable of replicating a large holographic optical element even while using, as a master, a diffractive optical element which is fabricated by a nanoimprint lithography method, is easier to fabricate and manage than a conventional holographic optical element and has better durability.

However, an object of the present disclosure is not limited to the above-mentioned object, and other objects not mentioned herein will be clearly understood by those skilled in the art from the following description.

An embodiment of the present disclosure provides a method for replicating a large holographic optical element, the method including: a placing step of placing a master which is composed of a diffractive optical element (DOE) having a diffraction grating pattern to be transferred as a holographic grating pattern to the holographic optical element, and a photocurable panel which has a larger area than the master and to which the holographic grating pattern formed by the diffraction grating pattern is to be transferred; a grating forming step of forming the holographic grating pattern on the photocurable panel by allowing a reference beam emitted from a light source to be incident on the master; and a movement step of forming the holographic grating pattern on the photocurable panel over a larger area than the master while moving the light source and the master at the same time or moving only the photocurable panel during incidence of the reference beam.

According to one embodiment of the present disclosure, a refractive index matching liquid may be applied between the master and the photocurable panel.

According to one embodiment of the present disclosure, the refractive index matching liquid may be applied to a transfer region, which is an exposed region of the photocurable panel, whenever the light source and the master are moved at the same time or only the photocurable panel is moved.

According to one embodiment of the present disclosure, the method further includes a refractive index matching liquid applying device placed in a moving direction of the transfer region and configured to apply the refractive index matching liquid, and the refractive index matching liquid may be applied whenever the transfer region changes.

According to one embodiment of the present disclosure, the amount of refractive index matching liquid applied may be determined based on the area of the transfer region and the moving speed of the photocurable panel.

According to one embodiment of the present disclosure, the master may be a panel on which a surface-relief grating (SRG) pattern corresponding to the diffraction grating pattern has been formed by a nanoimprint lithography (NIL) process.

According to one embodiment of the present disclosure, the master may be fabricated through steps of: imprinting the surface-relief grating pattern on a material panel for the master by using a master stamp having a pattern corresponding to the surface-relief grating pattern on the surface thereof; and curing the material panel having the surface-relief grating pattern imprinted thereon.

According to one embodiment of the present disclosure, the master may allow a reproduced beam generated by the master to travel in a single inclined direction.

According to one embodiment of the present disclosure, the method may further include, before the placing step: a master size determination step of determining the size of the master in consideration of each of the horizontal length and the vertical length of the large holographic optical element; and a step of fabricating the master according to the determined size of the master.

According to one embodiment of the present disclosure, the method may further include, before the placing step: a master size determination step of determining the size of the master such that the horizontal length of the large holographic optical element becomes a multiple of the horizontal length of the master and the vertical length of the large holographic optical element becomes a multiple of the vertical length of the master; and a step of fabricating the master according to the determined size of the master.

According to one embodiment of the present disclosure, the number of times the light source and the master move at the same time or only the photocurable panel moves in the movement step may be a value obtained by subtracting 1 from a value obtained by dividing the area of the large holographic optical element by the area of the master.

According to one embodiment of the present disclosure, the large holographic optical element may be a reflection type holographic optical element, the placing step may be a step of placing the photocurable panel between the light source from which the reference beam is emitted and the master, and the grating forming step may be a step of forming the holographic grating pattern by a reflected beam, which is reflected by the master and reaches the photocurable panel, and the reference beam which reaches the photocurable panel before reaching the master.

According to one embodiment of the present disclosure, the large holographic optical element may be a transmission type holographic optical element, the placing step may be a step of placing the master between the light source from which the reference beam is emitted and the photocurable panel, and the grating forming step may be a step of forming the holographic grating pattern by a transmitted beam, which passes through the master and reaches the photocurable panel, and a diffracted beam which is diffracted by the master and reaches the photocurable panel.

According to one embodiment of the present disclosure, the method may further include a step of bleaching the photocurable panel by irradiation with light having a wavelength in a ultraviolet-visible (UV-Vis) wavelength range.

Another embodiment of the present disclosure provides an apparatus for replicating a large holographic optical element, the apparatus including: a light source unit including a light source configured to irradiate, with a reference beam, a master which is composed of a diffractive optical element having a diffraction grating pattern to be transferred as a holographic grating pattern to the holographic optical element; a placement unit configured to place the master and a photocurable panel, which has a larger area than the master and to which the holographic grating pattern formed by the diffraction grating pattern is to be transferred; and a movement control unit configured to move the light source and the master at the same time or move only the photocurable panel so as to form the holographic grating pattern on the photocurable panel over a larger area than the master during incidence of the reference beam onto the master.

According to one embodiment of the present disclosure, a refractive index matching liquid may be applied to a transfer region, which is an exposed region of the photocurable panel, whenever the light source and the master are moved at the same time or only the photocurable panel is moved.

According to one embodiment of the present disclosure, the apparatus may further include a refractive index matching liquid applying device placed in a moving direction of the transfer region and configured to apply the refractive index matching liquid whenever the transfer region changes, and the amount of refractive index matching liquid applied may be determined based on the area of the transfer region, the moving speed of the light source and the master, or the moving speed of the photocurable panel.

According to one embodiment of the present disclosure, the master may allow a reproduced beam generated by the master to travel in a single inclined direction.

According to one embodiment of the present disclosure, the number of times the light source and the master move at the same time or only the photocurable panel moves may be a value obtained by subtracting 1 from a value obtained by dividing the area of the large holographic optical element by the area of the master.

According to one embodiment of the present disclosure, when the large holographic optical element is a reflection type holographic optical element, the photocurable panel may be placed between the light source and the master, and the holographic grating pattern may be formed by a reflected beam, which is reflected by the master and reaches the photocurable panel, and the reference beam which reaches the photocurable panel before reaching the master, and when the large holographic optical element is a transmission type holographic optical element, the master may be placed between the light source and the photocurable panel, and the holographic grating pattern may be formed by a transmitted beam, which passes through the master and reaches the photocurable panel, and a diffracted beam which is diffracted by the master and reaches the photocurable panel.

Still another embodiment of the present disclosure provides a large holographic optical element replicated by the method for replicating a large holographic optical element.

According to one embodiment of the present disclosure, the width of each seam between any one holographic grating pattern and other holographic grating patterns adjacent to the any one holographic grating pattern may be 0 µm to 800 µm.

According to one embodiment of the present disclosure, the area of seams between any one holographic grating pattern and other holographic grating patterns adjacent to the any one holographic grating pattern may be 0% to 15% of the total area of the large holographic optical element.

Specific details regarding other embodiments are included in the detailed description and the accompanying drawings.

### BRIEF DESCRIPTION OF THE DRAWINGS

FIG. 1 is a flow chart showing a method for replicating a large holographic optical element according to one embodiment of the present disclosure.
FIG. 2 is a view illustrating that a holographic optical element is replicated according to one embodiment of the present disclosure.
FIG. 3 is a view illustrating that a holographic optical element is replicated according to one embodiment of the present disclosure.
FIG. 4 is a view showing a method for replicating a reflection type holographic optical element according to one embodiment of the present disclosure.
FIG. 5 is a view showing a method for replicating a transmission type holographic optical element according to one embodiment of the present disclosure.
FIG. 6 is a view illustrating a situation in which a large holographic optical element is replicated according to one embodiment of the present disclosure.
FIG. 7 is a view illustrating a situation in which a large holographic optical element is replicated according to one embodiment of the present disclosure.
FIG. 8 is an enlarged photograph of a seam between any one holographic grating pattern and another holographic grating pattern adjacent to the any one holographic grating pattern.
FIG. 9 is a schematic view of a large holographic optical element fabricated to examine the percent area of the seams.

### DETAILED DESCRIPTION

Hereinafter, embodiments disclosed herein will be described in detail with reference to the accompanying drawings, wherein the same reference numerals are used to designate identical or similar components, and redundant description thereof will be omitted. The suffixes "module" and "unit" for components used in the following description are given or used together merely to facilitate drafting of the specification, and the suffixes themselves are not intended to give any distinct meanings or functions. In addition, in the following description of the embodiments disclosed herein, detailed description of well-known related technologies may be omitted when it obscures the subject matters of the embodiments. Furthermore, the accompanying drawings are intended merely to facilitate understanding of the embodiments disclosed herein, and it should be understood that the technical spirit disclosed herein is not limited by the accompanying drawings, and any modifications, equivalents or replacements are possible without departing from the spirit and technical scope of the present disclosure.

It should be understood that, although terms including an ordinal number, such as first, second, etc., may be used herein to describe various components, the components are not limited by the terms. These terms are used only for the purpose of distinguishing one component from other components.

It is to be understood that, when any component is referred to as being "connected" or "coupled" to another component, it may be connected or coupled directly to the other component, but other intervening components may also be present therebetween. On the other hand, it is to be understood that, when any component is referred to as being "connected" or "coupled" directly to another component, other intervening components are not present therebetween.

Singular expressions include plural expressions unless the context clearly indicates otherwise.

In the present specification, it should be understood that terms such as "include" and "have" are intended to denote the existence of stated characteristics, numbers, steps, operations, components, parts, or combinations thereof, but do not preclude the possibility of existence or addition of one or more other characteristics, numbers, steps, operations, components, parts, or combinations thereof.

Hereinafter, the present disclosure will be described in detail.

A light guide plate having a nanopatterned diffraction grating recorded thereon may be used to embody augmented reality glasses, a head mounted display (HMD), a head-up display (HUD), etc., which are augmented reality (AR) display devices for viewing real-world objects and backgrounds and virtual reality objects at the same time. This light guide plate may be referred to by various names such as a diffractive light guide plate, an optical element, a diffractive optical element, a grating pattern element, a hologram optical element, and a holographic optical element.

As this diffractive light guide plate is irradiated with various light beams, various images desired by a user may be output in three dimensions, and the user can simultaneously see the light beam transmitted through the diffractive light guide plate and the light beam diffracted from the diffractive light guide plate.

Examples of this diffractive light guide plate include a diffractive optical element (DOE) in which a surface-relief grating (SRG) pattern corresponding to a diffraction grating pattern has been formed by a nanoimprint lithography (NIL) process. In addition, examples of the diffractive light guide plate also include a holographic optical element (HOE) fabricated by a method of recording a volume holographic grating (VHG) on a photopolymer, which is a photocurable polymer resin, by interference lithography using a laser which is a coherent light source.

Technology for replicating a holographic optical element may use a holographic optical element or a diffractive optical element as a master to be replicated. Based on the principle that an object beam is generated when the master is irradiated with a reference beam, a holographic optical element is replicated by recording a holographic grating pattern, which is an interference pattern between the reference beam and the object beam, on a photopolymer.

For mass production of an AR display device, mass production of a holographic optical element is required, and technology for replicating the holographic optical element is required for this purpose. The process of replicating this holographic optical element is relatively simple, and thus mass production of the holographic optical element is possible. For a precise and uniform replication process, the quality of the master should be maintained in a uniform state for a long time. In view of this aspect, it is preferable to use, as a master, a diffractive optical element fabricated by a nanoimprint lithography (NIL) method rather than a holographic optical element fabricated by a volume holographic grating (VHG) recording method.

As augmented reality devices such as a vehicle head-up display (HUD) have developed and their uses have diversified, large-sized diffractive light guide plates have been required, but when a master fabricated by a nanoimprint lithography (NIL) method is used, a problem arises in that it is difficult to apply the large-sized diffractive light guide plate to replication of a large holographic optical element, because it is difficult to fabricate the master to have a large size. In addition, when an AR display device is embodied using a surface-relief grating (SRG) type diffractive optical element (DOE) fabricated by a nanoimprint lithography method, the user's view may be obstructed due to external light diffraction because the difference in the refractive index of the grating is as great as 0.5.

The method for replicating a large holographic optical element according to the present disclosure makes it possible to replicate a large holographic optical element having a holographic grating pattern embodied by a master through tiled replication of the master, even while using, as the master, a diffractive optical element which is fabricated by a nanoimprint lithography method, is easier to fabricate and manage than a conventional holographic optical element and has better durability. Accordingly, it is possible to reduce the process time and cost by simplifying the process of replicating the diffractive light guide plate. In addition, it is possible to replicate a large holographic optical element, which causes less visual obstruction by external light diffraction even while using a master manufactured by a nanoimprint lithography method. Since a holographic optical element has a relatively high angular selectivity, the degree of visual obstruction due to external light diffraction may be reduced. In addition, as a diffractive optical element fabricated by the nanoimprint lithography process is used as the master for the replication process, more precise replication of a holographic optical element with uniform quality can be sustained for a long time. A master stamp is fabricated by forming an embossed surface-relief grating pattern on quartz or the like by slope etching, and imprinting the embossed surface-relief grating pattern on a polymer to form an engraved surface-grating pattern corresponding thereto. Thereafter, a master is fabricated by imprinting the master stamp on a polymer to form the same surface-relief grating pattern as the embossed surface-relief grating pattern formed on the surface of quartz or the like. The fabricated master, that is, a diffractive optical element, can focus a diffracted beam in one direction, and thus may be used as a master for the process of replicating a holographic optical element. As the master is fabricated by the nanoimprint lithography process, there are advantages in that it is easy to control the pitch of the master, and since a stamp formed of a single matrix without another matrix becomes the master, the master has excellent durability and can maintain the same replica quality for a longer period of time.

Hereinafter, the method for replicating a large holographic optical element according to the present disclosure and each component used in the method will be described in detail with reference to each drawing.

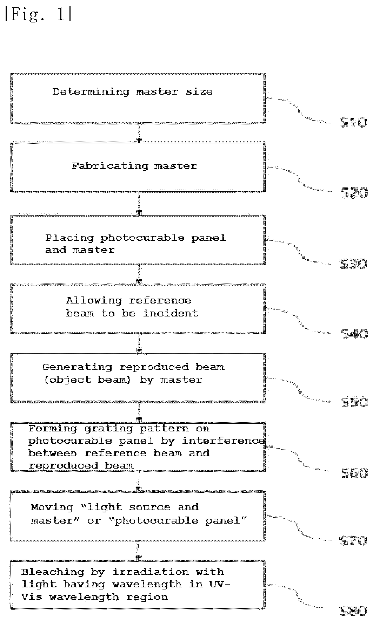

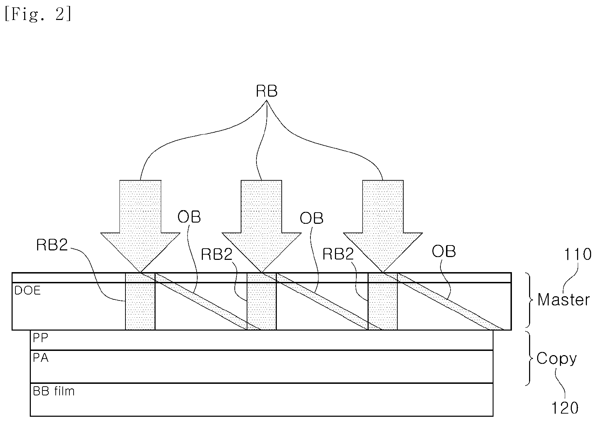

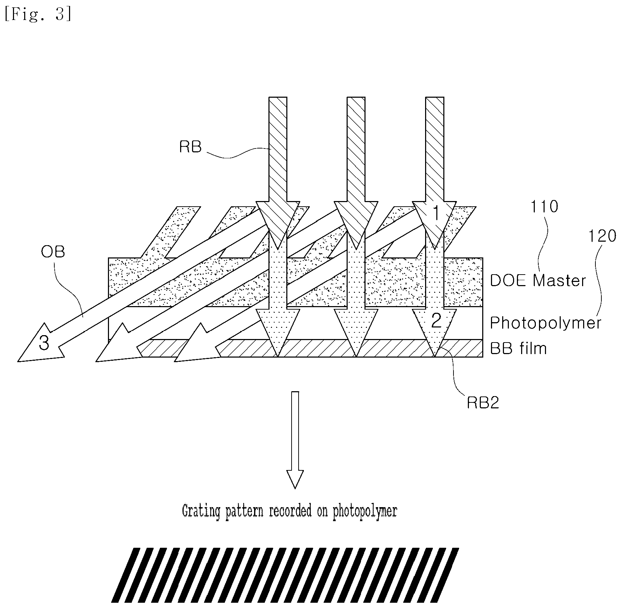

FIG. 1 is a flow chart showing a method for replicating a large holographic optical element according to one embodiment of the present disclosure. FIGS. 2 and 3 are views illustrating that a holographic optical element is replicated according to one embodiment of the present disclosure.

Hereinafter, the method for replicating a large holographic optical element will be described with reference to FIGS. 1 to 3.

The method for replicating a large holographic optical element according to the present disclosure may include: a placing step (S30) of placing a master which is composed of a diffractive optical element (DOE) having a diffraction grating pattern to be transferred as a holographic grating pattern to a holographic optical element, and a photocurable panel which has a larger area than the master and to which the holographic grating pattern formed by the diffraction grating pattern is to be transferred; a grating forming step (S40, S50 and S60) of forming the holographic grating pattern on the photocurable panel by allowing a reference beam emitted from a light source to be incident onto the master; and a movement step (S70) of forming the holographic grating pattern on the photocurable panel over a larger area than the master while moving the light source and the master at the same time or moving only the photocurable panel during incidence of the reference beam. In addition, the method for replicating a large holographic optical element according to the present disclosure may further include step (S10) of determining the size of the master and step (S20) of fabricating the master, before the placing step (S30). In addition, the method for replicating a large holographic optical element according to the present disclosure may further include step (S80) of performing ultraviolet-visible (UV-Vis) bleaching on the photocurable panel, that is, bleaching the photocurable panel by irradiation with light having a wavelength in a UV-Vis wavelength region, after completion of the movement step (S70).

Hereinafter, a photocurable panel 120 and a master 110 will be described with reference to FIGS. 2 and 3 before each step included in the present disclosure is described.

The photocurable panel 120 may be a panel-type material composed of a photocurable resin (a synthetic organic material that is crosslinked and cured by receiving light energy). For example, the photocurable panel 120 may be composed of a photopolymer. A holographic grating pattern formed by interference between two or more light beams may be recorded on the photocurable panel 120. A holographic optical element may be fabricated by recording a pattern, formed by interference between two or more light beams, on the photocurable panel 120.

The master 110 may be a diffractive light guide plate which has a diffraction grating pattern that can implement a holographic grating pattern to be replicated. In one embodiment of the present disclosure, the master 110 may be composed of a diffractive optical element. The master 110 may be a panel on which a surface-relief grating (SRG) corresponding to a diffraction grating pattern has been formed by a nanoimprint lithography (NIL) process. Since the master 110 is a panel fabricated by a nanoimprint lithography (NIL) process, it has advantages of better precision, uniformity and durability than a holographic optical element fabricated by interference between multiple light beams. That is, since the master 110 is composed of a diffractive optical element fabricated by a nanoimprint lithography (NIL) process, the replication method according to the present disclosure has advantages of better precision, uniformity and durability than a conventional replication method that uses a holographic optical element as the master 110. In addition, when a diffractive optical element is fabricated by a nanoimprint lithography process, the replication method according to the present disclosure also has an advantage in that it is possible to easily and precisely control the pitch of the diffractive optical element. Thus, in this case, the replication method can more precisely fabricate the master 110 having a diffraction grating pattern that can implement a desired holographic grating pattern to be replicated.

The master 110 may be fabricated through steps of: imprinting the diffraction grating pattern on a material panel for the master 110 by using a stamp for the master 110, which has a surface-relief grating pattern corresponding to the diffraction grating pattern on the surface thereof; and curing the material panel having the diffraction grating pattern transferred thereto. The stamp for the master 110 may be a stamp having a surface-relief grating pattern corresponding to the diffraction grating pattern to be formed on the master 110 in order to fabricate the master 110. The material panel for the master 110 may be a panel composed of a single material. On the other hand, the material panel for imprinting to fabricate the stamp for the master 110 may be a panel composed of quartz as a single material. After the material panel having the diffraction grating pattern imprinted thereon is cured, the fabrication of the master 110 to be used for replication is completed. The master 110 fabricated in this way may be in the form of a single material having a diffraction grating pattern formed thereon.

A diffraction grating pattern may be formed on the master 110. Specifically, the diffraction grating pattern formed on the master 110 may allow the diffracted light or reflected light generated by the master 110 to travel in a single inclined direction. In the process of replicating a holographic optical element, a pattern formed by interference between a reference beam RB and an object beam OB is recorded on the photocurable panel 120. However, where the pattern formed on the master 110 is not the diffraction grating pattern, unlike the embodiments shown in FIGS. 2 and 3, the reference beam RB incident onto the master 110 is diffracted in both directions, so that an interference pattern is recorded on the photopolymer by three directional beams (one reference beam RB passing through the master 110 and two directional beams diffracted in both directions), and hence inaccurate replication may proceed. As the diffraction grating pattern is formed on the master 110, the reference beam RB incident onto the master 110 is diffracted only in a single direction, so that an interference pattern is recorded on the photopolymer by two directional beams (the reference beam RB passing through the master 110 and the beam diffracted in a single direction), and accurate replication may proceed. In one embodiment of the present disclosure, the diffraction grating pattern may be in the form of a surface-relief grating of the master 110 such that the traveling direction of the object beam OB generated by the master 110 is inclined in a single direction.

The master 110 may be fabricated by imprinting a polymer with a single-material master mold having a surface-relief grating pattern formed by slope etching to fabricate a master stamp (master replication mold) having the surface-relief grating pattern formed thereon, and imprinting a polymer with the master stamp. In addition, the master mold may be made of quartz.

On the other hand, the master 110 may be fabricated using a single-material master stamp on which a surface-relief grating pattern corresponding to the diffraction grating pattern has been formed by slope etching. That is, a stamp for the master 110 is not a final imprint sample resulting from a nanoimprint photography process, but may be a stamp having a surface-relief grating formed by etching. Since the final imprint sample may be fabricated only when the stamp is additionally subjected to a soft mold process, it further requires a process of imprinting a pattern, unlike the stamp. When this process is performed, the quality as the master 110 is likely to be reduced, and the cost and time required to fabricate the master 110 may increase. In addition, the stamp is composed of a single substrate (for example, the material of the stamp may be quartz), whereas the imprint sample includes a glass or plastic substrate coated with imprint resist, and thus also has a problem in that the ease of washing, management and handling thereof is inferior. Accordingly, as the master 110, the quartz stamp may be more preferable than the imprint sample.

For example, specific specifications of the master 110 may be as follows. The master 110 may have a line pattern formed by slope etching and be composed of quartz alone. In this case, the refractive index of the quartz material may be 1.46. When the master 110 is fabricated by the nanoimprint lithography process, there is also an advantage in that it is easy to control the pitch of the master 110. For example, when the reference beam RB is a laser beam having a single wavelength of 532 nm, the pitch of the master 110 may be controlled to 405 nm. For example, recording conditions that are applied to the method for replicating a holographic optical element according to the present disclosure may be as follows. The reference beam RB may be a laser beam having a single wavelength. For example, the reference beam RB may be a laser beam having a single wavelength of 532 nm (green). The reference beam RB may be incident onto the master 110 at a predetermined intensity for a predetermined exposure time. For example, the predetermined intensity of the reference beam RB may be 1 mW/cm², and the predetermined exposure time may be any one of 5, 10, 15, and 20 seconds. In this case, the thickness of the photocurable panel 120 (photopolymer) may be any one of 8, 15, and 30 um. Hereinafter, each step of the method according to the present disclosure will be described in detail.

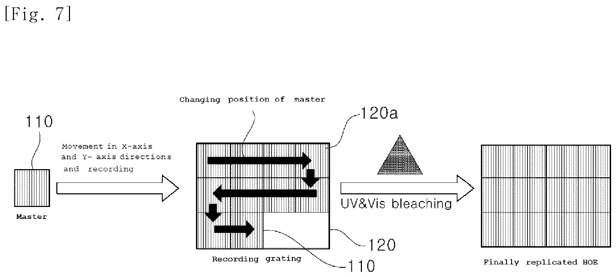

Step S10 in FIG. 1 is a step of determining the size of the master 110. The size of the master 110 may be determined in consideration of each of the horizontal and vertical lengths of the large holographic optical element. Specifically, the size of the master 110 may be determined such that the horizontal length of the large holographic optical element to be fabricated becomes a multiple of the horizontal length of the master 110 and the vertical length of the large holographic optical element becomes a multiple of the vertical length of the master 110. Referring to FIG. 7, the horizontal length of the photocurable panel 120 is four times the horizontal length of the master 110, and the vertical length of the photocurable panel 120 is three times the vertical length of the master 110. When the horizontal and vertical lengths of the master 110 are determined in this way, the effects of reducing the fabrication time and enhancing the fabrication efficiency are obtained, because the master 110 or the photocurable panel 120 only needs to move an integer number of times in order to fabricate a large holographic optical element. Accordingly, in the movement step S70, the number of times the light source and the master 110 move at the same time or only the photocurable panel 120 moves, that is, the number of movements of "light source and master 110" or "photocurable panel 120", may be a value obtained by subtracting 1 from a value obtained by dividing the area of the large holographic optical element by the area of the master 110. In this case, the large holographic optical element may be fabricated using the minimum number of movements, and thus the fabrication time is reduced and the fabrication efficiency is enhanced.

Step S20 in FIG. 1 is a step of fabricating the master 110. The step of fabricating the master 110 may include steps of: imprinting a diffraction grating pattern on a material panel for the master 110 by using a master stamp having the diffraction grating pattern to be imprinted on the master, that is, a surface-relief grating pattern; and curing the material panel having the diffraction grating pattern imprinted thereon. Accordingly, the diffraction grating pattern may be formed on the master 110, so that the reproduced beam generated by the master 110 may travel in a single inclined direction. At the top of the master 110 in FIG. 3, a diffraction grating pattern appears. The master stamp may be one obtained by imprinting a polymer with a master mold on which a surface-relief grating pattern corresponding to the above-described surface-relief grating pattern has been formed by etching the surface of quartz or the like. On the other hand, the master stamp may be one on which a surface-relief grating pattern corresponding to the diffraction grating pattern has been formed by etching the surface of quartz or the like.

Step S30 in FIG. 1 is a step of placing the photocurable panel 120 and the master 110. The photocurable panel 120 and the master 110 are placed side by side in close contact with each other over a large area, and a refractive index matching liquid (or a refractive index matching oil) 130 is placed between the master 110 and the photocurable panel 120. In the present disclosure, since the photocurable panel 120 and the master 110 move separately from each other, they are in a close contact state, not in an attached state, and the photocurable panel 120 and the master 110 are somewhat spaced apart from each other so that the refractive index matching liquid 130 can be applied therebetween.

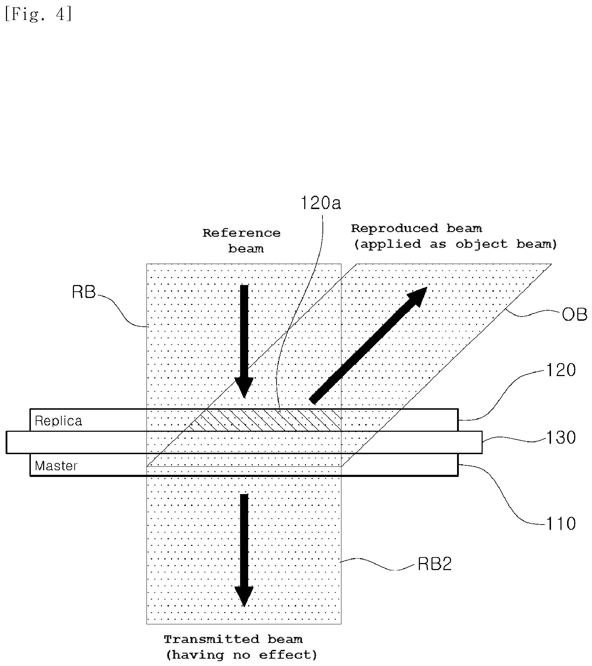

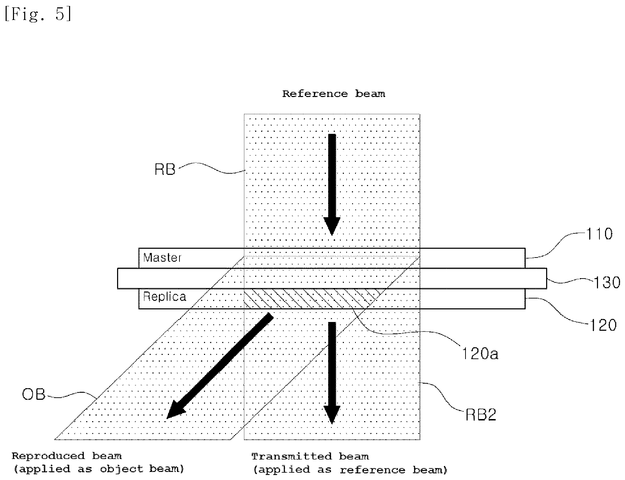

Referring to FIGS. 2 to 5, the photocurable panel 120 and the master 110 may be placed in various manners. According to the embodiments of FIGS. 2 and 3, when the reference beam RB is incident onto the top of the master 110, the photocurable panel 120 may be placed in close contact with the lower surface of the master 110. According to the embodiment shown in FIG. 4, when the reference beam RB is incident onto the top of the master 110, the photocurable panel 120 may be placed above the master 110, and the refractive index matching liquid 130 may be placed between the master 110 and the photocurable panel 120 in close contact therewith. According to the embodiment shown in FIG. 5, when the reference beam RB is incident onto the top of the master 110, the photocurable panel 120 may be placed under the master 110, and the refractive index matching liquid 130 may be placed between the master 110 and the photocurable panel 120 in close contact therewith.

In step S40 shown in FIG. 1, the reference beam RB is incident from a light source onto the master 110 and the photocurable panel 120. The light source may be a laser light source. The light source that is used in the present disclosure preferably emits highly coherent light. In this case, interference between various light beams may occur smoothly. Referring to FIGS. 2 and 3, it can be confirmed that the reference beam RB is incident onto the master 110.

In step S50 shown in FIG. 1, as the reference beam RB emitted from the light source reaches the master 110, a reproduced beam (object beam OB) is generated by the master 110. When the reference beam RB reaches the master 110, the reproduced beam OB may be generated due to the pattern due to the slope etching performed on the master 110. The reproduced beam OB may be a traveling beam generated by the reflection or diffraction of a portion of the reference beam RB that has reached the master 110. The master 110 generates the reproduced beam OB traveling in a single inclined direction. Accordingly, an interference pattern is recorded on the photocurable panel 120 by two directional beams (the reference beam RB passing through the master 110 and the diffracted beam diffracted in one direction), and accurate replication may proceed. Referring to FIGS. 2 and 3, it can be confirmed that the reproduced beam OB is generated by the master 110. In this embodiment, the reproduced beam OB travels in a single inclined direction due to the slope etching performed on the master 110. A transmitted beam RB2 traveling through the master 110 reaches the photocurable panel 120 in the same direction as the reference beam RB.

In step S60 shown in FIG. 1, as an interference pattern between the reference beam RB emitted from the light source and the reproduced beam (object light OB) generated by the master 110 is recorded on the photocurable panel 120, a grating pattern is formed on the photocurable panel 120. In this case, the formed grating pattern is a replication of the grating pattern formed on the master 110.

In step S70 shown in FIG. 1, a grating pattern is formed on the photocurable panel 120 over a larger area than the master 110 while the light source and the master are moved at the same tome or only the photocurable panel is moved. That is, a grating pattern is formed on the photocurable panel 120 over a larger area than the master 110 while "the light source and the master 110" or "the photocurable panel 120" moves during incidence of the reference beam. To this end, in the replication method according to the present disclosure, a device may be used, which moves "the light source and the master 110" or "the photocurable panel 120". When "the light source and the master 110" move, "the photocurable panel 120" is fixed, and when "the photocurable panel 120" moves, "the light source and the master 110" are fixed. Even if any of "the light source and the master 110" and "the photocurable panel 120" moves, the same effect occurs. When "the light source and the master 110" move, a device for moving "the light source and the master 110" and a device for fixing the photocurable panel 120 may be provided and used in the present disclosure. When the photocurable panel 120 moves, a device for fixing "the light source and the master 110" and a device for moving the photocurable panel 120 may be provided and used in the present disclosure. Such devices may have different configurations and functions depending on the case in which a reflection type holographic optical element is replicated and the case in which a transmission type holographic optical element is replicated.

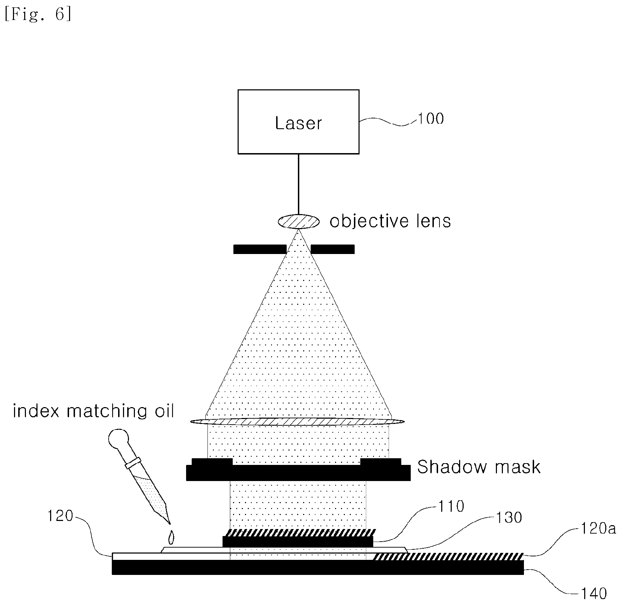

Between the master 110 and the photocurable panel 120, the refractive index matching liquid (or a refractive index matching oil) 130 is applied. Only when the refractive index matching liquid 130 is applied between the master 110 and the photocurable panel 120, "the light source and the master 110" or "the photocurable panel 120" may move in a state in which the master 110 and the photocurable panel 120 are in close contact with each other. According to one embodiment of the present disclosure, the refractive index matching liquid 130 may be applied to the entire photocurable panel 120 at once. According to another embodiment of the present disclosure, the refractive index matching liquid 130 may be applied to a transfer region, which is an exposed region of the photocurable panel 120, whenever "the light source and the master 110" or "the photocurable panel 120" moves. Specifically, the refractive index matching liquid may be applied to the transfer region, which is an exposed region of the photocurable panel, whenever the light source and the master are moved at the same time or only the photocurable panel is moved. That is, in this embodiment, the refractive index matching liquid 130 is not applied to the photocurable panel 120 at once, but may be applied to a transfer region which newly occurs whenever "the light source and the master 110" or "the photocurable panel 120" moves. To this end, an apparatus for fabricating a large holographic optical element according to the present disclosure may further include a device for applying the refractive index matching liquid 130. The device for applying the refractive index matching liquid 130 is placed in the moving direction of the transfer region with respect to the transfer region, and the refractive index matching liquid 130 is applied whenever the transfer region changes. Specifically, referring to FIG. 6, the device for applying the refractive index matching liquid 130 may be placed at the lateral side of the master 110 so that it may apply the refractive index matching liquid 130 whenever the master 110 or the photocurable panel 120 moves. Unlike the embodiment shown in FIG. 6, the device for applying the refractive index matching liquid 130 may be placed to surround the master 110. The amount of refractive index matching liquid 130 applied may be determined based on the area of the transfer region and the moving speed of the photocurable panel 120. For example, the amount of refractive index matching liquid 130 applied may be changed in proportion to the area of the transfer region and the moving speed of the photocurable panel 120. For example, the amount of refractive index matching liquid 130 applied may increase as the area of the transfer region or the moving speed of the photocurable panel 120 increases.

While the reference beam is incident, "the light source and the master 110" or "the photocurable panel 120" may move so that a grating pattern may be formed over the entire target area. The area of the photocurable panel 120 that is used in the present disclosure may be the same as the area of the large holographic optical element to be fabricated, but in other cases, the movement path of "the light source and the master 110" or "the photocurable panel 120" will be determined based on the area of the large holographic optical element to be fabricated.

In the embodiment shown in FIG. 7, a photopolymer that is the photocurable panel 120 moves in a zigzag manner, and accordingly, the position of the master 110 on the photocurable panel 120 changes in a zigzag manner. This movement path is determined according to the shape and size of the master 110 and the shape and size of the large holographic optical element to be fabricated. In step S10 of determining the size of the master 110, the size of the master 110 is determined such that the horizontal length of the large holographic optical element becomes a multiple of the horizontal length of the master 110 and the vertical length of the large holographic optical element becomes a multiple of the vertical length of the master 110. Accordingly, in the movement step S70, "the light source and the master 110" or "the photocurable panel 120" may move a number of times corresponding to a value obtained by subtracting 1 from a value obtained by dividing the area of the large holographic optical element by the area of the master 110. "The light source and the master 110 or "the photocurable panel 120" does not move continuously, but transfer is performed in a stationary state after the master 110 is located in a region where the grating pattern has not been formed. After the transfer is completed, "the light source and the master 110" or "the photocurable panel 120" moves to the next position in the region where the grating pattern has not been formed. In the present disclosure, this type of replication fixation is referred to as a tiling type replication process. The specific movement path may be variously set, such as a zigzag path in a horizontal direction, a zigzag path in a vertical direction, and a spiral path.

In step S80 shown in FIG. 1, ultraviolet-visible (UV-Vis) bleaching is performed on the photocurable panel 120 having the holographic grating pattern completely formed thereon. Specifically, the step is performed, which bleaches the photocurable panel by irradiation with light having a wavelength in the UV-Vis wavelength range. Accordingly, a large holographic optical element may be recorded on the photocurable panel 120.

FIG. 4 is a view illustrating a method for replicating a reflection type holographic optical element according to one embodiment of the present disclosure.

In the embodiment shown in FIG. 4, the holographic optical element to be replicated is a reflection type holographic optical element. In this case, the master 110 may be a reflection type diffractive optical element.

In the method for replicating the reflection type holographic optical element, the placing step may be a step of placing the photocurable panel 120 between the master 110 and the light source from which the reference beam RB is emitted. In this case, the refractive index matching liquid 130 for minimizing refraction may be placed between the master 110 and the photocurable panel 120. In this embodiment, a reflected beam is an object beam OB.

In the method for replicating a reflection type holographic optical element, the step of forming a grating pattern is a step of forming the grating pattern by a reflected beam (object beam OB), which is reflected by the master 110 and reaches the photocurable panel 120, and the reference beam RB which reaches the photocurable panel 120 before reaching the master 110. The reference beam RB emitted from the light source reaches the photocurable panel 120. The reflected beam (object beam OB) generated by the master 110 reaches the photocurable panel 120 in an inclined direction. The reference beam RB and the reflected beam (object beam OB), which have reached the photocurable panel 120, cause interference, and the interference pattern is recorded on the photocurable panel 120. The transmitted beam RB2 passing through the master 110 does not generate other effects in this embodiment.

The master 110 may have diffraction efficiency such that a beam ratio BR between the reflected beam (object beam OB) and the reference beam RB is 1:1. In this case, the master 110 may have the highest diffraction efficiency.

FIG. 5 is a view illustrating a method for replicating a transmission type holographic optical element according to one embodiment of the present disclosure.

In the embodiment shown in FIG. 5, the holographic optical element to be replicated is a transmission type holographic optical element. In this case, the master 110 may be a transmission type diffractive optical element.

In the method for replicating a transmission type holographic optical element, the placing step is a step of placing the master 110 between the photocurable panel 120 and the light source from which the reference beam RB is emitted. In this case, the refractive index matching liquid 130 for minimizing refraction may be placed between the master 110 and the photocurable panel 120. In this embodiment, the object light OB is a diffracted beam that is diffracted while passing through the master 110 and travels in an inclined direction.

In the method for replicating a transmission type holographic optical element, the step of forming a grating pattern is a step of forming the grating pattern by the transmitted beam RB2, which passes through the master 110 and reaches the photocurable panel 120, and a diffracted beam which is diffracted by the master 110 and reaches the photocurable panel 120. The reference beam RB emitted from the light source reaches the master 110 before reaching the photocurable panel 120. Thereafter, the transmitted beam RB2, which passes through the master 110 in the same direction as the reference beam RB, and the diffracted beam (object beam OB), which is diffracted by the master 110 and travels in an inclined direction, are generated. The transmitted beam RB2 and the diffracted beam (object beam OB) reach the photocurable panel 120. The transmitted beam RB2 and the diffracted beam (object beam OB), which have reached the photocurable panel 120, cause interference, and the interference pattern is recorded on the photocurable panel 120.

The master 110 may have diffraction efficiency such that the beam ratio (BR) between the reflected beam (object beam OB) and the reference beam RB is 1:1. In this case, the diffraction efficiency of the master 110 may be determined by an experiment.

FIGS. 6 and 7 are views each illustrating a situation in which a large holographic optical element is replicated according to one embodiment of the present disclosure.

In the embodiment shown in FIG. 6, an apparatus for performing the replication method of the present disclosure may include a laser light source, various lenses, and a shadow mask. In this embodiment, these devices are collectively referred to as light source devices. The light source devices allow the reference beam emitted from the laser light source to be incident onto the master 110 and the photocurable panel 120. In the embodiment shown in FIG. 6, the photocurable panel 120 moves to the right, and the master 110 and the light source devices are in a fixed state. On the other hand, when the master 110 and the light source move, the master 110 and the light source may move to the left, and the photocurable panel 120 may be in a fixed state. As the process according to the present disclosure proceeds, a region 120a in which a grating pattern has been already formed is present on the photocurable panel 120. The photocurable panel 120 may move to the right so that the master 110 can be placed on a region where the grating pattern has not been formed next to the region 120a in which the grating pattern has been formed. When the photocurable panel 120 moves, the refractive index matching liquid 130 is applied through the device for applying the refractive index matching liquid, and the refractive index matching liquid 130 is placed in an exposed region of the photocurable panel 120. As the refractive index matching liquid 130 is applied, the photocurable panel 120 may be maintained in close contact with the master 110 without a change in the refractive index while the photocurable panel 120 moves. After the placement of the master 110 is completed, the reference beam is incident until a grating pattern is formed in the corresponding area. In this case, the reference beam may be incident for a predetermined time. After the formation of the grating pattern is completed, the photocurable panel 120 moves again so that the master 110 can be placed on the area where the grating pattern has not been formed.

In the embodiment shown in FIG. 7, the photocurable panel 120 made of the photopolymer moves in a zigzag manner, and accordingly, the position of the master 110 on the photocurable panel 120 changes in a zigzag manner. In this embodiment, the horizontal length of the large holographic optical element to be fabricated is four times the horizontal length of the master 110, and the vertical length of the large holographic optical element is three times the vertical length of the master 110. Accordingly, the photocurable panel 120 moves a total of 11 times to replicate one large holographic optical element. The photocurable panel 120 moves so that the grating pattern of the master 110 is formed in the entire area of the photocurable panel 120. After the grating pattern of the master 110 is formed in the entire area of the photocurable panel 120, ultraviolet-visible (UV-Vis) bleaching is performed, and replication of the holographic optical element is completed.

One embodiment of the present disclosure provides an apparatus for replicating a large holographic optical element, the apparatus including: a light source unit 100 including a light source configured to irradiate, with a reference beam, the master 110 which is composed of a diffractive optical element having a diffraction grating pattern to be transferred as a holographic grating pattern to the holographic optical element; a placement unit 140 configured to place the master 110 and the photocurable panel 120, which has a larger area than the master 110 and to which the holographic grating pattern formed by the diffraction grating pattern is to be transferred; and a movement control unit (not shown) configured to move the light source and the master at the same time or move only the photocurable panel so as to form the holographic grating pattern on the photocurable panel over a larger area than the master during incidence of the reference beam onto the master.

The apparatus for replicating a large holographic optical element according to one embodiment of the present disclosure may enhance the precision and uniformity of the replication method while fabricating a diffractive optical element with a large area.

Throughout the present specification, contents overlapping with those described above with respect to the method for replicating a holographic optical element will be omitted.

According to one embodiment of the present disclosure, the apparatus includes the light source unit 100 including a light source configured to irradiate, with a reference beam, the master 110 which is composed of a diffractive optical element having a diffraction grating pattern to be transferred as a holographic grating pattern to the holographic optical element. Specifically, the light source unit 100 may include: the light source that emits the reference beam so as to irradiate the master 110 with the reference beam; a lens that diffuses the reference beam so that a parallel beam can be diffused while the emitted light source is transmitted through the lens; and a slit that controls an area onto which the beam transmitted through the lens while it passes through the slit. As described above, as the master 110 composed of a diffractive optical element having the diffraction grating pattern to be transferred is irradiated with the beam emitted from the light source unit 100, the transmitted beam passing through the master 110 acts as a reference beam, and the reproduced beam diffracted by the master acts as an object beam, whereby a holographic grating pattern formed by interference between the object beam and the reference beam is replicated. As described above, the apparatus includes the light source unit 100 including the light source configured to irradiate, with a reference beam, the master 110 which is composed of a diffractive optical element having a diffraction grating pattern to be transferred as a holographic grating pattern to the holographic optical element, and thus may enhance the accuracy of the holographic grating pattern to be replicated while controlling the pattern.

According to one embodiment of the present disclosure, the apparatus includes the placement unit 140 configured to place the master 110 and the photocurable panel 120, which has a larger area than the master 110 and to which the holographic grating pattern formed by the diffraction grating pattern is to be transferred. Specifically, in order to replicate the diffraction grating pattern of the master, the photocurable panel 120 or the master 110 must be placed at a specific position, and thus it may be provided on the placement unit 140. Where the photocurable panel 120 is placed and fixed on the placement unit 140, the holographic grating pattern may be transferred to the photocurable panel 120 while the master 110 moves, and where the photocurable panel 120 is placed on the placement unit 140 and the master 110 is fixed on the placement unit 140, the holographic grating pattern may be transferred while the photocurable panel 120 moves. Furthermore, the photocurable panel 120 may be configured to have a larger area than the master 110, so that the diffraction grating pattern of the master 110 can be replicated on the photocurable panel over a larger area. As the apparatus includes the placement unit 140 as described above, the photocurable panel 120 or the master 110 may be fixed and the holographic grating pattern formed by the diffraction grating pattern may be replicated on the photocurable panel 120.

According to one embodiment of the present disclosure, the apparatus includes a movement control unit (not shown) which moves the light source unit 100 and the master 110 at the same time or moves only the photocurable panel 120 so as to form the holographic grating pattern on the photocurable panel 120 over a larger area than the master during incidence of the reference beam onto the master. Specifically, the process of moving the light source unit 100 and the master 110 at the same time or moving only the photocurable panel 120 by the movement control unit may be embodied in the same manner as described above with respect to the method for replicating a large holographic optical element. As described above, as the movement control unit (not shown) moves the light source unit 100 and the master 110 at the same time or by moving only the photocurable panel 120, it is possible to enhance the precision and uniformity of the holographic grating pattern to be transferred.

According to one embodiment of the present disclosure, whenever the light source and the master are moved at the same time or only the photocurable panel is moved, the refractive index matching liquid may be applied to a transfer region that is an exposed region of the photocurable panel. As described above, as the refractive index matching liquid may be applied to a transfer region that is an exposed region of the photocurable panel whenever the light source and the master are moved at the same time or only the photocurable panel is moved, it is possible to minimize vibration generated during movement of the master and the photocurable panel and to minimize friction between the master and the photocurable panel.

According to one embodiment of the present disclosure, the apparatus may further include a refractive index matching liquid applying device which is placed in the moving direction of the transfer region with respect to the transfer region and applies the refractive index matching liquid whenever the transfer region changes, and the amount of refractive index matching liquid applied may be determined based on the area of the transfer region and the moving speed of the light source and the master or the moving speed of the photocurable panel. As described above, as the apparatus further includes a refractive index matching liquid applying device which is placed in the moving direction of the transfer region with respect to the transfer region and applies the refractive index matching liquid whenever the transfer region changes, and as the amount of refractive index matching liquid applied is determined based on the area of the transfer region and the moving speed of the light source and the master or the moving speed of the photocurable panel, it is possible to solve the problem caused by the excessive application of the refractive index matching liquid.

Specifically, the refractive index matching liquid (or a refractive index matching oil) 130 is applied between the master 110 and the photocurable panel 120. Only when the refractive index matching liquid 130 is applied between the master 110 and the photocurable panel 120, "the light source and the master 110" or "the photocurable panel 120" may move in a state in which the master 110 and the photocurable panel 120 are in close contact with each other. According to one embodiment of the present disclosure, the refractive index matching liquid 130 may be applied to the entire photocurable panel 120 at once. According to another embodiment of the present disclosure, the refractive index matching liquid 130 may be applied to a transfer region, which is an exposed region of the photocurable panel 120, whenever "the light source and the master 110" or "the photocurable panel 120" moves. Specifically, the refractive index matching liquid may be applied to a transfer region, which is an exposed region of the photocurable panel, whenever the light source and the master are moved at the same time or only the photocurable panel is moved. That is, in this embodiment, the refractive index matching liquid 130 is not applied to the photocurable panel 120 at once, but may be applied to a transfer region which newly occurs whenever "the light source and the master 110" or "the photocurable panel 120" moves. To this end, the apparatus for fabricating a large holographic optical element according to the present disclosure may further include a device for applying the refractive index matching liquid 130. The device for applying the refractive index matching liquid 130 is placed in the moving direction of the transfer region with respect to the transfer region, and the refractive index matching liquid 130 is applied whenever the transfer region changes. Specifically, referring to FIG. 6, the device for applying the refractive index matching liquid 130 may be placed at the lateral side of the master 110 so that it may apply the refractive index matching liquid 130 whenever the master 110 or the photocurable panel 120 moves. Unlike the embodiment shown in FIG. 6, the device for applying the refractive index matching liquid 130 may be placed to surround the master 110. The amount of refractive index matching liquid 130 applied may be determined based on the area of the transfer region and the moving speed of the photocurable panel 120. For example, the amount of refractive index matching liquid 130 applied may be changed in proportion to the area of the transfer region and the moving speed of the photocurable panel 120. For example, the amount of refractive index matching liquid 130 applied may increase as the area of the transfer region or the moving speed of the photocurable panel 120 increases.

According to one embodiment of the present disclosure, the master may allow the reproduced light generated by the master to travel in a single inclined direction. As the master allows the reproduced light generated by the master to travel in a single inclined direction as described above, it is possible to enhance the accuracy of the holographic grating pattern being transferred.

According to one embodiment of the present disclosure, the number of times the light source and the master 110 move at the same time or only the photocurable panel 120 moves may be a value obtained by subtracting 1 from a value obtained by dividing the area of the large holographic optical element by the area of the master 110. As described above, as the number of times the light source and the master 110 move at the same time or only the photocurable panel 120 moves is set to a value obtained by subtracting 1 from a value obtained by dividing the area of the large holographic optical element by the area of the master 110, it is possible to minimize the time taken to replicate the holographic optical element by minimizing the number of times the light source and the master move at the same time or only the photocurable panel moves.

According to one embodiment of the present disclosure, where the large holographic optical element is a reflection type holographic optical element, the photocurable panel may be placed between the light source and the master, and the holographic grating pattern may be formed by a reflected beam, which is reflected by the master and reaches the photocurable panel, and the reference beam which reaches the photocurable panel before reaching the master. Where the large holographic optical element is a transmission type holographic optical element, the master may be placed between the light source and the photocurable panel, and the holographic grating pattern may be formed by a transmitted beam, which passes through the master and reaches to the photocurable panel, and a diffracted beam which is diffracted by the master and reaches the photocurable panel. As the emitted light is controlled as described above, it is possible to easily fabricate a desired holographic optical element.

Still another embodiment of the present disclosure provides a large holographic optical element replicated by the method for replicating a large holographic optical element.

The large holographic optical element according to one embodiment of the present disclosure is effective in that the ease of fabrication and management of a master used for replication is improved.

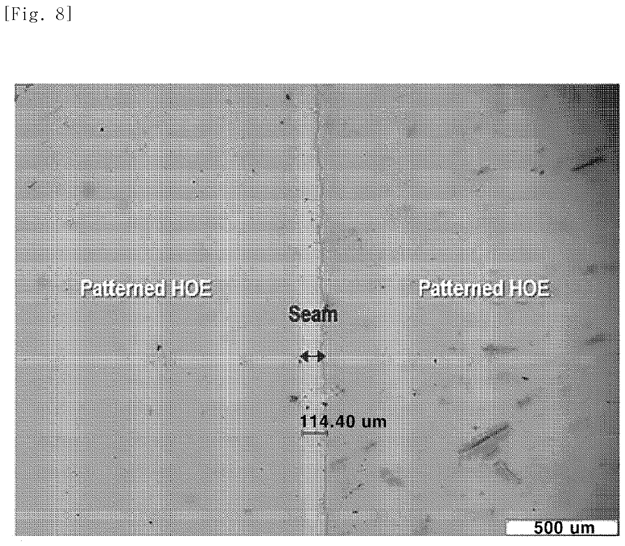

According to one embodiment of the present disclosure, the width of each seam between any one holographic grating pattern and other holographic grating patterns adjacent to the any one holographic grating pattern may be 0 um to 800 um. FIG. 8 is an enlarged photograph of a seam between any one holographic grating pattern and another holographic grating pattern adjacent to the any one holographic grating pattern. Referring to FIG. 8, the term "seam" as used throughout the specification may refer to the spacing between any one holographic grating pattern and other holographic grating patterns formed around the any one holographic pattern, that is, any one holographic grating pattern and other holographic grating patterns adjacent to the any one holographic grating pattern. Specifically, the width of each seam between any one holographic grating pattern and other holographic grating patterns adjacent to the any one holographic grating pattern may be 0 µm to 790 pm, 0 µm to 780 pm, 0 µm to 770 pm, 0 µm to 760 pm, 0 µm to 750 pm, 0 µm to 740 pm, 0 µm to 730 pm, 0 µm to 720 pm, or 0 µm to 710 µm. The width of the seam may be measured using an optical microscope (Olympus, BX51, x5 magnification) after replication of the large holographic optical element. As the width of the seam is controlled within the above-described range, it is possible to improve the precision and uniformity of the large holographic optical element.

According to one embodiment of the present disclosure, the area of the seams between any one holographic grating pattern and other holographic grating patterns adjacent to the any one holographic grating pattern may be 0% to 15% of the total area of the large holographic optical element. Specifically, the area of the seams between any one holographic grating pattern and other holographic grating patterns adjacent to the any one holographic grating pattern may be 0% to 14%, 0% to 13%, 0% to 12%, 0% to 11%, 0% to 10%, 0% to 9%, 0% to 8%, 0% to 7%, 0% to 6%, 0% to 5%, 0% to 4%, 0% to 3%, 0% to 2%, or 0% to 1% of the total area of the large holographic optical element. As the area of the seams is controlled within the above-described range, it is possible to improve the precision and uniformity of the large holographic optical element. Furthermore, as the width of the seam is controlled within the above-described range, it is possible to control the area of the seams.

### <Example>

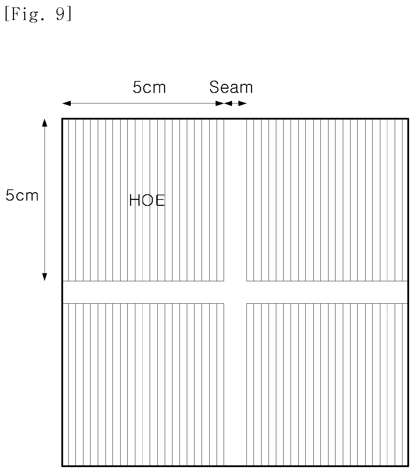

FIG. 9 is a schematic view of a large holographic optical element fabricated to examine the percent area of seams. As shown in FIG. 9, a large holographic optical element having four holographic grating patterns, each having a size of 5 cm x 5 cm, was replicated using a refractive index matching liquid according to the method for replicating a large holographic optical element according to the present disclosure. The width and percent area of seams between the holographic grating patterns were measured using an optical microscope (Olympus, BX51, x5 magnification), and the results of the measurement are summarized in Table 1 below.

### <Comparative Example>

As shown in FIG. 9, a large holographic optical element having four holographic grating patterns, each having a size of 5 cm x 5 cm, was replicated without using the refractive index matching liquid by a method of attaching the master to be transferred, replicating the holographic grating patterns and then removing the master. The width and percent area of seams between the holographic grating patterns were measured using an optical microscope (Olympus, BX51, x5 magnification), and the results of the measurement are summarized in Table 1 below.

**[Table 1]**

| | Width of seam | Percent area of seams |
|---|---|---|
| Example | 700 µm | 130 |
| Comparative Example | More than 900 µm | More than 16% |

Referring to Table 1 above, it was confirmed that, in the case of the Example, the percent area of the seams was decreased by decreasing the width of each seam, suggesting that the precision and uniformity of the large holographic optical element were improved.

On the other hand, it was confirmed that, in the case of the Comparative Example in which the large holographic optical element was fabricated without using the refractive index matching liquid by the method of attaching the master to be transferred, copying the holographic grating patterns and then removing the master, the width of each seam excessively increased, and for this reason, the percent area of the seams increased, suggesting that the precision and uniformity of the large holographic optical element were reduced.

In conclusion, according to the method for replicating a large holographic optical element according to one embodiment of the present disclosure and a large holographic optical element replicated thereby, it is possible to replicate a large holographic optical element even while using, as a master, a diffractive optical element which is fabricated by a nanoimprint lithography method, is easier to fabricate and manage than a conventional holographic optical element and has better durability, and it is possible to improve the precision and uniformity of the large holographic optical element.

As described above, the method for replicating a large holographic optical element according to one embodiment of the present disclosure is effective in that a large holographic optical element may be replicated even while using, as a master, a diffractive optical element fabricated by a nanoimprint lithography (NIL) process, and thus the precision and uniformity of the replication method are improved while the holographic optical element may be fabricated with a large area.

The apparatus for replicating a large holographic optical element according to one embodiment of the present disclosure may improve the precision and uniformity of the replication method while fabricating a diffractive optical element with a large area.

The large holographic optical element according to one embodiment of the present disclosure is effective in that the ease of fabrication and management of a master used for replication is improved.

Effects of the present disclosure are not limited to the above-described effects, and effects not mentioned herein will be clearly understood by those skilled in the art from the present specification and the accompanying drawings.

The above detailed description should be considered to be illustrative in all respects and not restrictive. The scope of the present disclosure should be determined by reasonable interpretation of the appended claims, and all changes which comes within the equivalent scope of the present disclosure are included within the scope of the present disclosure. Although the present disclosure has been described with reference to the above-mentioned preferred embodiments, various modifications and variations are possible without departing from the subject matter and scope of the present disclosure. Therefore, it is intended that the present disclosure embraces such modifications and variations as fall within the scope of the appended claims.

## Claims

1. A method for replicating a large holographic optical element, the method comprising:
placing a master which is composed of a diffractive optical element having a diffraction grating pattern to be transferred as a holographic grating pattern to a holographic optical element, and a photocurable panel which has a larger area than that of the master and to which the holographic grating pattern formed by the diffraction grating pattern is to be transferred;
forming the holographic grating pattern on the photocurable panel by allowing a reference beam emitted from a light source to be incident onto the master; and
forming the holographic grating pattern on the photocurable panel over a larger area than that of the master while moving the light source and the master at the same time or moving only the photocurable panel during incidence of the reference beam.

2. The method of claim 1, wherein a refractive index matching liquid is applied between the master and the photocurable panel.

3. The method of claim 2, wherein the refractive index matching liquid is applied to a transfer region, which is an exposed region of the photocurable panel, when the light source and the master are moved at the same time or only the photocurable panel is moved.

4. The method of claim 3,
further comprising a refractive index matching liquid applying device placed in a moving direction of the transfer region and configured to apply the refractive index matching liquid,
wherein the refractive index matching liquid is applied when the transfer region changes.

5. The method of claim 4, wherein an amount of refractive index matching liquid applied is determined based on an area of the transfer region and a moving speed of the photocurable panel.

6. The method of claim 1, wherein the master is a panel on which a surface-relief grating (SRG) pattern corresponding to the diffraction grating pattern has been formed by a nanoimprint lithography (NIL) process.

7. The method of claim 6, wherein the master is fabricated by imprinting the surface-relief grating pattern on a material panel for the master by using a master stamp having a pattern corresponding to the surface-relief grating pattern formed on a surface thereof; and
curing the material panel having the surface-relief grating pattern imprinted thereon.

8. The method of claim 1, wherein the master allows a reproduced beam generated by the master to travel in a single inclined direction.

9. The method of claim 1, further comprising:
prior to placing of the master, determining a size of the master based on each of a horizontal length and vertical length of the large holographic optical element; and
fabricating the master according to the determined size of the master.

10. The method of claim 9, further comprising:
prior to placing of the master, determining the size of the master such that the horizontal length of the large holographic optical element becomes a multiple of the horizontal length of the master and the vertical length of the large holographic optical element becomes a multiple of the vertical length of the master; and
fabricating the master according to the determined size of the master.

11. The method of claim 10, wherein the number of times the light source and the master move at the same time or only the photocurable panel moves is a value obtained by subtracting 1 from a value obtained by dividing the area of the large holographic optical element by the area of the master.

12. The method of claim 1, wherein
the large holographic optical element is a reflection type holographic optical element,
wherein the placing of the master comprises placing the photocurable panel between the light source from which the reference beam is emitted and the master, and
wherein forming of the holographic grating pattern further comprises forming the holographic grating pattern by a reflected beam, which is reflected by the master and reaches the photocurable panel, and the reference beam which reaches the photocurable panel before reaching the master.

13. The method of claim 1, wherein
the large holographic optical element is a transmission type holographic optical element,
wherein the placing of the master comprises placing the master between the light source from which the reference beam is emitted and the photocurable panel, and
wherein forming of the holographic grating pattern further comprises forming the holographic grating pattern by a transmitted beam, which passes through the master and reaches the photocurable panel, and a diffracted beam which is diffracted by the master and reaches the photocurable panel.

14. The method of claim 1, further comprising bleaching the photocurable panel by irradiation with light having a wavelength in a ultraviolet-visible (UV-Vis) wavelength range.

15. An apparatus for replicating a large holographic optical element, the apparatus comprising:
a light source unit comprising a light source configured to irradiate, with a reference beam, a master which is composed of a diffractive optical element having a diffraction grating pattern to be transferred as a holographic grating pattern to the holographic optical element;
a placement unit configured to place the master and the photocurable panel, which has a larger area than that of the master and to which the holographic grating pattern formed by the diffraction grating pattern is to be transferred; and
a movement control unit configured to move the light source and the master at the same time or move only the photocurable panel so as to form the holographic grating pattern on the photocurable panel over a larger area than that of the master during incidence of the reference beam onto the master.

16. The apparatus of claim 15, wherein a refractive index matching liquid is applied to a transfer region, which is an exposed region of the photocurable panel, when the light source and the master are moved at the same time or only the photocurable panel is moved.

17. The apparatus of claim 16,
further comprising a refractive index matching liquid applying device placed in a moving direction of the transfer region and configured to apply the refractive index matching liquid when the transfer region changes,
wherein an amount of refractive index matching liquid applied is determined based on an area of the transfer region, a moving speed of the light source and the master, or a moving speed of the photocurable panel.

18. The apparatus of claim 15, wherein the master allows a reproduced beam generated by the master to travel in a single inclined direction.

19. The apparatus of claim 15, wherein the number of times the light source and the master move at the same time or only the photocurable panel moves is a value obtained by subtracting 1 from a value obtained by dividing the area of the large holographic optical element by the area of the master.

20. The apparatus of claim 15, wherein,
when the large holographic optical element is a reflection type holographic optical element, the photocurable panel is placed between the light source and the master, and the holographic grating pattern is formed by a reflected beam, which is reflected by the master and reaches the photocurable panel, and the reference beam which reaches the photocurable panel before reaching the master; and
when the large holographic optical element is a transmission type holographic optical element, the master is placed between the light source and the photocurable panel, and the holographic grating pattern is formed by a transmitted beam, which passes through the master and reaches the photocurable panel, and a diffracted beam which is diffracted by the master and reaches the photocurable panel.

21. A large holographic optical element replicated by the method for replicating a large holographic optical element according to claim 1.

22. The large holographic optical element of claim 21, wherein a width of each seam between any one holographic grating pattern and other holographic grating patterns adjacent to the any one holographic grating pattern is 0 µm to 800 µm.

23. The large holographic optical element of claim 21, wherein an area of seams between any one holographic grating pattern and other holographic grating patterns adjacent to the any one holographic grating pattern is 0% to 15% of the total area of the large holographic optical element.
